# EUROPÄISCHE PATENTANMELDUNG

(11) **EP 2 107 339 A2**
(43) Veröffentlichungstag der Anmeldung: **07.10.2009**
(21) Anmeldenummer: 09002729.3
(22) Anmeldetag: 26.02.2009
(51) Int. Cl.: G01C 21/32

(54) **Verfahren zur Erzeugung einer elektronischen Adressdatenbank, Verfahren zur Durchsuchung einer elektronischen Adressdatenbank und Navigationsgerät mit einer elektronischen Adressdatenbank**

(30) Priorität: 11.03.2008 DE 102008013637; 05.05.2008 DE 102008022184
(71) Anmelder: Navigon AG, 20251 Hamburg (DE)
(72) Erfinder: Körtge, Harald, 97204 Höchberg (DE)
(74) Vertreter: Böck, Bernhard

(57) **Zusammenfassung**

Die Erfindung betrifft ein Verfahren zur Erzeugung einer auf einem elektronischen Speichermedium speicherbaren Adressdatenbank, in der Ortsangaben, insbesondere Ortsnamen und Straßennamen, durch eine Vielzahl von Adressdatensätzen beschrieben sind, mit folgenden Verfahrensschritten:
a) Laden einer Ausgangsdatenbank, in der zumindest ein Teil eines Gesamtdatenbestandes von Adressdatensätzen gespeichert ist, in eine elektronische Analyseeinrichtung,
b) Analyse der Adressdatensätze in der Ausgangsdatenbank, wobei mehrere Adressdatensätze jeweils in einen Datenabschnitt und einen dem Datenabschnitt vorangestellten oder nachgestellten Trennabschnitt umcodiert werden,
c) Erzeugung einer sequentiellen Folge von umcodierten Adressdatensätzen, in der die Datenabschnitte getrennt durch die jeweils zugeordneten Trennabschnitte hintereinander angeordnet sind,
d) Speicherung der sequentiellen Folge von umcodierten Adressdatensätzen als neue Adressdatenbank.

## Beschreibung

Die Erfindung betrifft ein Verfahren zur Erzeugung einer elektronischen Adressdatenbank. Weiter betrifft die Erfindung ein Verfahren zur Durchsuchung einer solchen Adressdatenbank und ein Navigationsgerät, auf dem eine solche Adressdatenbank installiert ist. Adressdatenbanken werden beispielsweise, jedoch keineswegs ausschließlich, in Navigationsgeräten benötigt, um mögliche Zielpunkte zu identifizieren. Jeder Adresse, beispielsweise der Kombination aus einem Städtenamen, einem Straßennamen und einer Hausnummer, wird dabei eine bestimmte geographische Position oder ein Straßenelement-Identifier zugeordnet. Gibt der Benutzer dann eine bestimmte Adresse ein, so wird die Adressdatenbank nach dieser Adresse durchsucht. Sobald die Adresse aufgefunden wurde, kann beispielsweise in einem Navigationsgerät der gesuchten Adresse eine bestimmte geographische Position zugeordnet und anschließend eine Route zum Anfahren dieser geographischen Position berechnet werden.

Bekannte Adressdatenbanken sind häufig in einer Tabellen- oder Baumstruktur aufgebaut, um eine möglichst effiziente Suche zu ermöglichen. Dabei ist der Adressdatenbestand häufig indiziert, um eine hohe Suchgeschwindigkeit zu erzielen. Nachteilig an diesen indizierten Adressdatenbanken ist es jedoch, dass der für die Speicherung der Adressdatenbank erforderliche Speicherbedarf sehr hoch ist. Zudem müssen alle Teilstrings indiziert werden, was bei Straßennamen wie "Straße des 17. Juni" sehr aufwändig ist.

Weiter sind auch Adressdatenbanken bekannt, die ein so genanntes "Smartspelling" ermöglichen. Beim Smartspelling können nur korrekte Namen eingegeben werden, da abhängig von den Voreingaben jeweils nur die Buchstaben zur Auswahl angeboten werden, für die eine Auswahl auch möglich ist. Die Smartspelling-Adressdatenbanken sind üblicherweise baumförmig strukturiert und erfordern ebenfalls einen sehr hohen Speicherbedarf.

Ausgehend von diesem Stand der Technik ist es Aufgabe der vorliegenden Erfindung, ein Verfahren zur Erzeugung einer neuen Art von Adressdatenbank vorzuschlagen, die die Nachteile des vorbekannten Stands der Technik vermeidet. Dabei sollte insbesondere eine schnelle und effiziente Adresseingabe, wie sie beispielsweise bei Navigationssystemen erforderlich ist, bei Zurverfügungstellung begrenzter Ressourcen sowohl in Bezug auf die Prozessorkapazität als auch in Bezug auf die Speicherkapazität im Hauptspeicher erreicht werden. Weiter ist es Aufgabe der vorliegenden Erfindung, ein Suchverfahren zur Durchsuchung entsprechend erzeugter Adressdaten vorzuschlagen. Darüber hinaus wird auch ein Navigationsgerät vorgeschlagen, auf dem eine in dieser Weise erzeugte Adressdatenbank gespeichert ist.

Ausgangspunkt des erfindungsgemäßen Verfahrens ist eine Ausgangsdatenbank, in der die Adressdaten in konventioneller Weise durch eine Vielzahl von Adressdatensätzen gespeichert sind. Es kann sich dabei beispielsweise um eine Ausgangsdatenbank mit Tabellen- oder Baumstruktur handeln. Selbstverständlich kann die Ausgangsdatenbank auch nur einen Teil eines Gesamtdatenbestands der für den Betrieb eines bestimmten Geräts erforderlichen Adressdaten enthalten. Diese Ausgangsdatenbank wird zunächst in eine elektronische Analyseeinrichtung geladen.

In der Analyseeinrichtung wird eine Datenanalyse der in der Ausgangsdatenbank enthaltenen Adressdatensätze vorgenommen. Jeder einzelne Adressdatensatz wird anschließend in einen Datenabschnitt und einen dem Datenabschnitt vorangestellten oder nachgestellten Trennabschnitt umcodiert.

Aus den Datenabschnitten und den jeweils zugeordneten Trennabschnitten wird anschließend eine sequentielle Folge von umcodierten Adressdatensätzen erzeugt. Dabei ist es entweder möglich, dass zunächst alle Adressdatensätze umcodiert und dann gemeinsam zu einer Folge von umcodierten Adressdatensätzen zusammengestellt werden, oder dass schrittweise nacheinander jeweils ein Adressdatensatz umcodiert und anschließend in der Zeichenfolge der umcodierten Adressdatensätze einsortiert wird. Diese sequentielle Zeichenfolge aus Datenabschnitten und Trennabschnitten wird dann als neue Adressdatenbank abgespeichert. Erfindungsgemäß wird also eine Adressdatenbank erzeugt, in der die Adressdaten in einer linearen Zeichenfolge (Datenstring) enthalten sind. Die Zeichenfolge besteht dabei aus einer Kette von jeweils abwechselnd angeordneten Datenabschnitten und Trennabschnitten. Der erste und/oder letzte Datensatz in der Zeichenfolge kann dabei auch ohne Trennabschnitt abgespeichert werden. Jeweils ein Datenabschnitt und ein zugeordneter Trennabschnitt sind dabei einem Adressdatensatz der Ausgangsdatenbank eindeutig zuordenbar.

Um die Suche von Suchadressen in der Folge von umcodierten Adressdatensätzen zu vereinfachen, ist es besonders vorteilhaft, wenn die Datenabschnitte jeweils alphabetisch nach der Buchstabenfolge in der zeitlichen Folge einsortiert werden. Dies bedeutet beispielsweise, dass Städtenamen, die mit "A" beginnen vor Städtenamen einsortiert werden, die mit "B" beginnen. Weiterhin bedeutet dies, dass beispielsweise der Städtename "Aachen" vor dem Städtenamen "Aalen" und dieser wiederum vor dem Städtenamen "Augsburg" einsortiert wird. Zwischen den einzelnen Datenabschnitten befindet sich jeweils ein Trennabschnitt, der beispielsweise aus einem einzelnen Trennzeichen oder mehreren Trennzeichen bestehen kann.

Welche Art von Trennabschnitt bei der Umcodierung der Adressdatensätze erzeugt wird, ist grundsätzlich beliebig und hängt ab vom jeweiligen Anwendungsfall. Um die spätere Durchsuchung der erfindungsgemäß erzeugten Adressdatenbank zu erleichtern, ist es besonders vorteilhaft, wenn im Trennabschnitt ein Übereinstimmungswert abgespeichert wird. Der Übereinstimmungswert charakterisiert dabei die Anzahl der übereinstimmenden Einzelzeichen des jeweils codierten Adressdatensatzes mit den bereits umcodierten Adressdatensätzen. Bei der Suche von Adressen in der Folge von umcodierten Adressdatensätzen kann die Auswertung der Übereinstimmungswerte sehr hilfreich sein.

Insbesondere ermöglicht die Abspeicherung von Übereinstimmungswerten auch die Datenverdichtung in der Adressdatenbank, um Speicherplatz zur Speicherung der Adressdatenbank einzusparen. Um dies zu erreichen, kann bei der Umcodierung eines Adressdatensatzes dieser Adressdatensatz jeweils mit dem Adressdatensatz verglichen werden, der als letztes mit einem Übereinstimmungswert "0" in der Folge von umcodierten Adressdatensätzen abgespeichert wurde. Dabei ist es vorteilhaft, wenn als Übereinstimmungswert der ASCII-Wert 0 verwendet wird. Ein Adressdatensatz, der mit dem Übereinstimmungswert "0" in der Folge von umcodierten Adressdatensätzen abgespeichert wurde, charakterisiert sich dadurch, dass er mit den vorhergehend abgespeicherten Adressdatensätzen keine Gemeinsamkeiten in der Folge von umcodierten Adressdatensätzen aufwies. Sobald der letzte mit einem Übereinstimmungswert "0" in der Folge von umcodierten Adressdatensätzen abgespeicherte Adressdatensatz identifiziert ist, wird der aktuell umzucodierende Adressdatensatz hinsichtlich seines Präfixes mit dem Präfix des Adressdatensatzes mit dem Übereinstimmungswert "0" verglichen. Die Anzahl der übereinstimmenden Einzelzeichen des Präfixes wird dann als Präfixübereinstimmungswert als neuer Trennabschnitt abgespeichert und zugleich der umzucodierende Adressdatensatz nach Kürzung um das Präfix als neuer Datenabschnitt gespeichert.

Sollen beispielsweise die Städtenamen "Aachen", "Aalen" und "Augsburg" gespeichert werden, so wird aufgrund der alphabetischen Sortierung zunächst Aachen abgespeichert, wobei Aachen aufgrund der fehlenden Übereinstimmung mit einem vorhergehenden Adressdatensatz der Trennabschnitt <0> vorangestellt wird. Es entsteht also zunächst die Zeichenfolge :<0>AAchen.

Anschließend soll dann der Städtenamen "Aalen" in der Folge von umcodierten Adressdatensätzen abgespeichert werden. Beim Vergleich des Städtenamens Aalen mit dem zuvor mit dem Übereinstimmungswert "0" abgespeicherten Städtenamen Aachen wird festgestellt, dass beide Städtenamen im Präfix "AA" übereinstimmen. Deshalb wird zum Städtenamen Aalen ein Präfixübereinstimmungswert "Zwei" im neuen Trennabschnitt <2> abgespeichert und der Städtenamen "Aalen" um das Präfix "AA" gekürzt im zugeordneten Datenabschnitt abgespeichert. Nach der Abspeicherung dieses zweiten Trennabschnitts und des zweiten Datenabschnitts entsteht folgende Zeichenkette:
<0>AACHEN<2>LEN

Das Präfix "AA" wird also durch den Trennabschnitt <2> codiert.

Soll nun auch der Städtename "Augsburg" in der Folge von umcodierten Adressdatensätzen abgespeichert werden, wird Augsburg wiederum mit Aachen verglichen, da dies der letzte Datenabschnitt mit einem Präfixübereinstimmungswert "0" ist. Dabei wird festgestellt, dass "Aachen" nur im Präfix "A" mit "Aachen" übereinstimmt. Deshalb wird zu dem Adressdatensatz Augsburg ein Präfixübereinstimmungswert "Eins" im Trennabschnitt <1> abgespeichert. Diesem Trennabschnitt wird der Datenabschnitt "UGSBURG" abgespeichert. Die Folge von umcodierten Adressdatensätzen nach der Abspeicherung des Städtenamens "Augsburg" sieht dann nach der Umcodierung wie folgt aus:
<0>AACHEN<2>LEN<1>UGSBURG

Als Präfixübereinstimmungswerte im Trennabschnitt können die ASCII-Zeichen, beispielsweise mit einem Wertebereich von 0 bis 31, zwischen den Städtenamen verwendet werden, wobei die jeweilige Zahl angibt, in welcher Anzahl von Einzelzeichen die Präfixe der einzelnen Städtenamen identisch übereinstimmen.

Weiterhin vorteilhaft bei der Durchsuchung der erfindungsgemäß erzeugten Datenbank ist es, wenn in regelmäßigen Abständen der Folge von umcodierten Adressdatensätzen jeweils ein umcodierter Datenabstand mit einem Übereinstimmungswert "0" abgespeichert ist. Beispielweise kann jeder 32ste Adressdatensatz oder jeder 64ste Adressdatensatz in einen umcodierten Datenabschnitt überführt und so in der Folge von umcodierten Adressdatensätzen abgespeichert werden. Bei der Durchsuchung der erfindungsgemäß erzeugten Adressdatenbank hat dies den Vorteil, dass die fortgesetzten Suchabfragen, die bereits Teilmengen ausgeschlossen haben, größere Blöcke von Datenabschnitten in der Folge von umcodierten Adressdatensätzen überspringen können. 32 oder 64 Datenabschnitte bilden dabei jeweils ein Bitfeld und können mit aktuellen Prozessoren sehr effektiv geprüft werden.

Eine weitere Optimierung der Adressdatenbank im Hinblick auf den notwendigen Speicherplatz kann durch die Identifikation von häufig identisch wiederkehrenden Wortfragmenten mit jeweils einer identischen Folge von zusammenhängenden Einzelzeichen erreicht werden. So ist z.B. in der Liste der deutschen Straßennamen das Wortfragment "Straße" und das Wortfragment "Weg" sehr häufig anzutreffen. In der Liste der deutschen Städtenamen finden sich häufig die Wortfragmente "Stadt", "Berg" und "Burg". Diese identischen Wortfragmente können durch das nachfolgend beschriebene Verfahren auf geeignet gewählte Tokenelemente abgebildet werden, und auf diese Weise kann Speicherplatz eingespart werden. Dazu werden zunächst in den Adressdatensätzen der Ausgangsdatenbank Wortfragmente mit einer identischen Folge von zusammenhängenden Einzelzeichen identifiziert. Die identifizierten Wortfragmente sind dabei dadurch charakterisiert, dass sie in einer Vielzahl von Adressdatensätzen jeweils identisch enthalten sind. Jedem dieser auf diese Weise identifizierten Wortfragmente wird ein Tokenelement, beispielsweise eine kurze Folge von umcodierten Adressdatensätzen von ASCII-Zeichen, eindeutig zugeordnet. Das auf diese Weise erzeugte Tokenelement wird abgespeichert und kann durch entsprechende Abfrage das zugeordnete Wortfragment eindeutig repräsentieren.

Bei der Umcodierung eines Adressdatensatzes wird der Adressdatensatz dann darauf hin geprüft, ob eines der gespeicherten Tokenelemente enthalten ist. Ist dies der Fall, wird das entsprechend identifizierte Wortfragment des Adressdatensatzes durch das zugeordnete Tokenelement ersetzt. Im Städtenamen "Augsburg" kann beispielsweise das Wortfragment "burg" durch das zugeordnete Tokenelement x1 ersetzt werden. Der Städtenamen "Augsburg" würde also nach Ersetzung des Wortfragments "burg" durch das Tokenelement "x1" sowie der Einkürzung nach dem oben beschriebenen Ablauf in folgender Weise abgespeichert: <1>UGSx1.

Die Identifikation von Wortfragmenten in den Adressdatensätzen und deren Ersetzung durch Tokenelemente sollte erst nach der Umcodierung der Präfixe des Adressdatensatzes erfolgen, da ansonsten die präfixbasierte Durchsuchung der erfindungsgemäß erzeugten Adressdatensätze nicht durchgeführt werden kann.

In welcher Weise die einzelnen Adressdatenbanken zur Speicherung der erforderlichen Adressdaten strukturiert sind, ist grundsätzlich beliebig. Bevorzugt sollte für die Städtenamen der Ausgangsdatenbank eine Hauptadressdatenbank mit einer Folge von umcodierten Adressdatensätzen erzeugt werden, wobei diese Zeichenfolge dann alle Städtenamen der Ausgangsdatenbank in umcodierter Form enthält.

Parallel zur Hauptadressdatenbank mit den Städtenamen kann auch noch für jede Stadt eine Unteradressdatenbank erzeugt werden, die die Straßennamen jeder zugeordneten Stadt in einer Folge von umcodierten Adressdatensätzen enthält.

Alternativ können für die nachgelagerte Suche von Straßen nach vorheriger Selektion einer Stadt, d.h. bei einer Adresseingabe wurde die Stadt bereits ermittelt, die betreffenden Straßen(-namen), die für diese Stadt relevant sind, ermittelt werden, indem aus der Gesamtliste aller Straßen bzw. Gesamtliste aller Straßen in den Kacheln, also Teilen, in die die Karte aufgeteilt ist, in der sich die Stadt befindet, diejenigen identifiziert werden, die der Stadt zugeordnet sind. Damit werden dann nur diese bei der Durchführung des erfindungsgemäßen Verfahrens berücksichtigt. Vorteilhaft ist hier der Einsatz von Bitfeldern, welche jedem Datensatz in der Gesamtstraßenliste nach Identifikation der Stadt den Wert 1 => 'wahr' für 'zur Stadt gehörig' oder 0 => 'falsch' für 'nicht zur Stadt gehörig' zuordnen. Diese Bitfelder werden dann bei der Durchführung des erfindungsgemäßen Verfahrens auf die Gesamtstraßenliste als Filter eingesetzt, mit dem bestimmt wird, ob eine Straße berücksichtigt wird oder nicht.

Des Weiteren ist es vorteilhaft, dass eine Straße nur einmal in der Gesamtstraßenliste vorkommt, unabhängig davon, in wie vielen Städten sie vorkommt.

Weiterhin vorteilhaft ist es, die Adressdatensätze der Ausgangsdatenbank, beispielsweise die Straßen- und Städtenamen, vor der Abspeicherung in der Folge von umcodierten Adressdatensätzen gemäß einem vorgegebenen Normalisierungsschema in einem Normalisierungsmodul auf eine Grundform zu normalisieren. Dadurch würde beispielsweise der Straßenname "Champs-Elysées" auf die Schreibweise "champs elysee" normalisiert, wobei insbesondere auch die Groß- und Kleinschreibung vereinheitlicht wird. Auch alle anderen, denkbaren Schreibweisen des gleichen Namens würden auf eine Grundform normalisiert und die Datenmenge entsprechend reduziert. Bei der Suche in der Datenbank würde die Suchadresse ebenfalls entsprechend normalisiert.

Die erfindungsgemäß erzeugte Adressdatenbank bietet auch bei der Suche nach Adressen erhebliche Vorteile, insbesondere wenn eine Präfixcodierung vorgenommen wurde. Bei der Suche nach einem Adressbestandteil wird der entsprechende Suchstring in ein elektronisches Suchmodul geladen und nachfolgend sequentiell der Suchstring mit den Datenabschnitten und den Trennabschnitten in einer Folge von umcodierten Adressdatensätzen der Adressdatenbank verglichen. Wird bei diesem Vergleich eine Ungleichheit des Präfix des Suchstrings mit dem Präfix eines Datenabschnitts identifiziert, werden anschließend alle auf diesen Datenabschnitt folgenden Datenabschnitte, die sich über ihren Trennabschnitt auf das gleiche Präfix zurück beziehen, übersprungen. Auf diese Weise können große Blöcke von Datenabschnittsfolgen in einfacher Weise übersprungen werden, ohne dass dazu ein Vergleich der einzelnen Zeichen im Suchstring notwendig wäre.

Soweit in der Datenbank häufig auftretende Wortfragmente durch Tokenelemente codiert sind, sollten auch bei der Suche nach einzelnen Adressen die entsprechenden Wortfragmente im Suchstring durch die vorgespeicherten Tokenelemente ersetzt werden. Auf diese Weise kann dann die Suche durch den Vergleich der jeweiligen Tokenelemente vereinfacht werden.

Des Weiteren ist es vorteilhaft, wenn für so genannte kritische Pfade ein Index bei der Erstellung der Datenbank generiert wird. Kritische Pfade sind z.B. Buchstaben oder Buchstabenkombinationen, die in einer großen Anzahl der Datensätze vorkommen.

Ist die Adressdatenbank hierarchisch mit einer Hauptadressdatenbank zur Speicherung der Städtenamen und einer Vielzahl von Unteradressdatenbanken zur Speicherung der Straßennamen in den einzelnen Städten strukturiert, so wird auch die Suche stufenweise durchgeführt. Das heißt, zuerst wird der gesuchte Städtename in der Hauptadressdatenbank gesucht und anschließend die der aufgefundenen Stadt der Hauptadressdatenbank zugeordnete Unteradressdatenbank mit den darin gespeicherten Straßennamen der Stadt durchsucht.

In welcher Art von Geräten die erfindungsgemäß erzeugte Adressdatenbank genutzt wird, ist grundsätzlich beliebig. Besonders große Vorteile bietet die erfindungsgemäß erzeugte Adressdatenbank in Navigationsgeräten, insbesondere in mobilen Navigationsgeräten, damit in der erfindungsgemäßen Adressdatenbank zum einen der notwendige Speicherplatz reduziert und zum anderen die erforderliche Prozessorperformance zurückgenommen werden kann.

Aufgrund der Datenreduktion ist es insbesondere auch möglich, die Adressdatenbank sowohl im Permanentspeicher als auch im Arbeitsspeicher des Navigationsgeräts abzuspeichern.

Bei Verwendung der Adressdatenbank in einem Navigationsgerät sollte jeder Adresse der Adressdatenbank eine bestimmte geographische Position oder ein Straßenelement-Identifier zugeordnet sein.

## Patentansprüche

1. Verfahren zur Erzeugung einer auf einem elektronischen Speichermedium speicherbaren Adressdatenbank, in der Ortsangaben, insbesondere Ortsnamen und Straßennamen, durch eine Vielzahl von Adressdatensätzen beschrieben sind, mit folgenden Verfahrensschritten:
a) Laden einer Ausgangsdatenbank, in der zumindest ein Teil eines Gesamtdatenbestandes von Adressdatensätzen gespeichert ist, in eine elektronische Analyseeinrichtung,
b) Analyse der Adressdatensätze in der Ausgangsdatenbank, wobei mehrere Adressdatensätze jeweils in einen Datenabschnitt und einen dem Datenabschnitt vorangestellten oder nachgestellten Trennabschnitt umcodiert werden,
c) Erzeugung einer sequentiellen Folge von umcodierten Adressdatensätzen, in der die Datenabschnitte getrennt durch die jeweils zugeordneten Trennabschnitte hintereinander angeordnet sind,
d) Speicherung der sequentiellen Folge von umcodierten Adressdatensätzen als neue Adressdatenbank.

2. Verfahren nach Anspruch 1,
**dadurch gekennzeichnet,**
**dass** die Datenabschnitte in der sequentiellen Folge von umcodierten Adressdatensätzen alphabetisch sortiert werden.

3. Verfahren nach Anspruch 1 oder 2,
**dadurch gekennzeichnet,**
**dass** bei der Umcodierung eines Adressdatensatzes jeweils analysiert wird, in wie vielen zusammenhängenden Einzelzeichen der Adressdatensatz mit einem bereits umcodierten Adressdatensatz übereinstimmt, wobei die Anzahl der übereinstimmenden Einzelzeichen als Übereinstimmungswert im zugeordneten Trennabschnitt abgespeichert wird.

4. Verfahren nach Anspruch 3,
**dadurch gekennzeichnet,**
**dass** bei der Umcodierung eines Adressdatensatzes dieser Adressdatensatz mit dem Adressdatensatz verglichen wird, der als letztes mit einem Übereinstimmungswert Null in der sequentiellen Folge von umcodierten Adressdatensätzen abgespeichert wurde, wobei dann analysiert wird, in wie vielen zusammenhängenden Einzelzeichen das Präfix des Adressdatensatzes mit diesem bereits umcodierten Adressdatensatz übereinstimmt, wobei die Anzahl der übereinstimmenden Einzelzeichen des Präfix als Präfixübereinstimmungswert als neuer Trennabschnitt abgespeichert wird, und wobei der um das Präfix gekürzte Adressdatensatz als neuer Datenabschnitt gespeichert wird.

5. Verfahren nach Anspruch 3 oder 4,
**dadurch gekennzeichnet,**
**dass** in regelmäßigen Abständen der sequentiellen Folge von umcodierten Adressdatensätzen, insbesondere jeweils nach 32 oder 64 Datenabschnitten, ein umcodierter Datenabschnitt mit einem Übereinstimmungswert Null abgespeichert wird.

6. Verfahren nach einem der Ansprüche 1 bis 5,
**dadurch gekennzeichnet,**
**dass** in den Adressdatensätzen der Ausgangsdatenbank Wortfragmente mit einer identischen Folge von zusammenhängenden Einzelzeichen identifiziert werden, die in einer Vielzahl von Adressdatensätzen jeweils identisch enthalten sind, wobei jedem dieser Wortfragmente ein Tokenelement eindeutig zugeordnet und gespeichert wird, wobei jedes Tokenelement die Folge von zusammenhängenden Einzelzeichen eines Wortfragments repräsentiert, und wobei bei der Umcodierung eines Adressdatensatzes in den Adressdatensätzen Wortfragmente durch Vergleich mit den gespeicherten Tokenelementen identifiziert werden, und wobei jedes in einem Adressdatensatz identifizierte Wortfragment durch das zugeordnete Tokenelement ersetzt wird.

7. Verfahren nach Anspruch 6,
**dadurch gekennzeichnet,**
**dass** die Identifikation der Wortfragmente in einem Adressdatensatz und die Ersetzung durch ein Tokenelement nach der Umcodierung des Präfix des Adressdatensatzes erfolgt.

8. Verfahren nach einem der Ansprüche 1 bis 7,
**dadurch gekennzeichnet,**
**dass** für die Städtenamen der Ausgangsdatenbank eine Hauptadressdatenbank mit einer sequentiellen Folge von umcodierten Adressdatensätzen erzeugt wird.

9. Verfahren nach einem der Ansprüche 1 bis 8,
**dadurch gekennzeichnet,**
**dass** für die Straßennamen jeder Stadt der Ausgangsdatenbank eine Unteradressdatenbank mit einer sequentiellen Folge von umcodierten Adressdatensätzen erzeugt wird.

10. Verfahren nach einem der Ansprüche 1 bis 9,
**dadurch gekennzeichnet,**
**dass** die Adressendatensätze der Ausgangsdatenbank in einem Normalisierungsmodul gemäß einem vorgegebenen Normalisierungsschema auf eine Grundform normalisiert werden.

11. Verfahren zur Durchsuchung einer auf einem elektronischen Speichermedium gespeicherten Adressdatenbank, die nach einem Verfahren nach den Ansprüchen 1 bis 10 erzeugt wurde:
a) Laden eines Suchstrings in ein elektronisches Suchmodul,
b) sequentieller Vergleich des Suchstrings mit den Datenabschnitten und Trennabschnitten in der sequentiellen Folge von umcodierten Adressdatensätzen der Adressdatenbank, wobei bei Identifikation der Ungleichheit des Präfix des Suchstrings mit dem Präfix eines Datenabschnitts alle auf diesen Datenabschnitt folgenden Datenabschnitte, die sich über ihren Trennabschnitt auf das Präfix dieses Datenabschnitts rückbeziehen, übersprungen werden.

12. Verfahren nach Anspruch 11,
**dadurch gekennzeichnet,**
**dass** im Suchstring Wortfragmente aus zusammenhängenden Einzelzeichen identifiziert werden, denen ein Tokenelement bei der Erzeugung der Adressdatenbank zugeordnet ist, wobei das Wortfragment des Suchstrings durch das Tokenelement ersetzt wird.

13. Verfahren nach Anspruch 11 oder 12,
**dadurch gekennzeichnet,**
**dass** nach Eingabe einer Suchadresse mit einem Städtenamen und einem Straßennamen zuerst eine Hauptadressdatenbank mit allen in der sequentiellen Folge von umcodierten Adressdatensätzen der Hauptadressdatenbank gespeicherten Städtenamen durchsucht wird, und anschließend die zu der bei der Suche in der Hauptadressdatenbank identifizierten Stadt gespeicherte Unteradressdatenbank mit allen in der sequentiellen Folge von umcodierten Adressdatensätzen der Unteradressdatenbank gespeicherten Straßenamen der Stadt durchsucht wird.

14. Navigationsgerät mit einem Speicher, in dem eine digitale Adressdatenbank abgespeichert ist,
**dadurch gekennzeichnet,**
**dass** die Adressdatenbank nach einem Verfahren nach den Ansprüchen 1 bis 11 erzeugt wurde.

15. Navigationsgerät nach Anspruch 14,
**dadurch gekennzeichnet,**
**dass** die Adressdatenbank im Permanentspeicher und im Arbeitsspeicher des Navigationsgeräts abgespeichert ist.

16. Navigationsgerät nach Anspruch 14 oder 15,
**dadurch gekennzeichnet,**
**dass** jeder Adresse in der sequentiellen Folge von umcodierten Adressdatensätzen der Adressdatenbank eine bestimmte geographische Position oder ein Straßenelement-Identifier zugeordnet ist.
